# EUROPÄISCHE PATENTSCHRIFT

(11) **EP 0 632 940 B1**
(45) Veröffentlichungstag und Bekanntmachung des Hinweises auf die Patenterteilung: **18.10.2000**
(21) Anmeldenummer: 93905148.8
(22) Anmeldetag: 25.02.1993
(51) Int. Cl.: H04B 1/00, H03M 7/40

(54) **VERFAHREN ZUR DATENREDUKTION BEI DER SPEICHERUNG UND/ODER ÜBERTRAGUNG DIGITALER AUDIOSIGNALE FÜR STUDIO-ANWENDUNGEN**
DATA COMPRESSION PROCESS DURING STORAGE AND/OR TRANSMISSIOIN OF DIGITAL AUDIO SIGNALS FOR STUDIO APPLICATIONS
PROCEDE DE REDUCTION DE DONNEES LORS DE LA MEMORISATION ET/OU DE LA TRANSMISSION DE SIGNAUX AUDIO NUMERIQUES POUR APPLICATIONS EN STUDIO

(30) Priorität: 23.03.1992 DE 4209382
(43) Veröffentlichungstag der Anmeldung: 11.01.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: BRANDENBURG, Karl-Heinz, D-8520 Erlangen (DE); HERRE, Jürgen, D-8520 Erlangen (DE); SEITZER, Dieter, D-8520 Erlangen (DE)
(86) Internationale Anmeldenummer: DE9300177
(87) Internationale Veröffentlichungsnummer: WO9319536

(56) Entgegenhaltungen:
- DE-A- 3 912 605
- DE-A- 3 930 760
- US-A- 4 546 342
- US-A- 4 656 500
- US-A- 5 028 995
- "ASPEC Coding", Proceedings of the 10th International AES Conference, London 1991, Seiten 81 bis 90

## Beschreibung

### Technisches Gebiet

Die Erfindung bezieht sich auf ein Verfahren zur Datenreduktion bei der Speicherung und/oder Übertragung digitaler Audiosignale gemäß dem Oberbegriff des Anspruchs 1.

Solche Datenreduktions-Verfahren werden eingesetzt, wenn bei der Speicherung und/oder Übertragung von Audiosignalen zwar eine störungsfreie hohe Tonqualität erreicht werden soll, aber keine so hohe Übertragungs- oder Speicherbandbreite, wie beispielsweise bei einer Compact Disc (CD) zur Verfügung steht.

Beispiele sind der geplante digitale terrestrische Rundfunk, der Tonkanal von digitalen Videorecordern oder Bandaufzeichnungsgeräte mit stationärem Tonkopf und viele mehr.

### Stand der Technik

Ein Verfahren gemäß dem Oberbegriff ist beispielsweise durch die deutsche Offenlegungsschrift DE-OS 39 12 605 bekannt geworden.

Bei diesem Verfahren erfolgt die Codierung der quantisierten Spektralwerte mit einem Optimalcodierer, bei dem das zur Codierung verwendete Codewort umso kürzer ist, je häufiger der Spektralkoeffizient auftritt. Dabei wird der Code einer Tabelle entnommen, deren Länge der Anzahl der Codewörter entspricht (Huffmancode).

Je nach zu codierendem Signal werden Code-Tabellen mit unterschiedlicher Länge verwendet. Zusammen mit den codierten Werten muß dann die Nummer der verwendeten Code-Tabelle übertragen bzw. gespeichert werden.

Eine Weiterentwicklung dieses Verfahrens ist in der Veröffentlichung "ASPEC Coding", Proceedings of the 10^{th} International AES Conference, London 1991, S. 81-90, beschrieben. Bei diesem Verfahren werden die Optimalcodierung, ein verbessertes psychoakustisches Modell und verbesserte Maßnahmen zur Überwindung von sogenannten Vorechos vereint.

Dabei wird eine Modifizierten Diskrete Cosinus Transformation eingesetzt, die perfekte Rekonstruktionseigenschaften aufweist, das heißt, daß das Ausgangssignal der inversen Transformation mit dem Eingangssignal übereinstimmt, wenn keine Quantisierung vorgenommen wird.

Auf die genannten Druckschriften wird zur Erläuterung aller hier nicht näher beschriebenen Begriffe ausdrücklich Bezug genommen.

Mit Hilfe des letztgenannten Verfahrens ist es gelungen, Musik mit Bitraten von nur 64 kbit/sec pro Kanal in CD-Qualität zu übertragen, wobei Unterschiede zwischen dem Original-Signal und dem übertragenen Signal praktisch nicht wahrnehmbar sind.

Die Anforderungen an die meisten Anwendungen für die Verbraucher können damit erfüllt werden.

Jedoch sind bisher bekannte Verfahren zur Datenreduktion für professionelle Anwendungen in Studios nur begrenzt einsetzbar. Das liegt daran, daß Nachbearbeitungen, wie Mischen, Überblenden oder Mehrfachcodierung und -decodierung das Signal so verändern, daß zunächst verdeckte, durch das Codierverfahren hervorgerufene Störungen, hörbar werden.

### Darstellung der Erfindung

Aufgabe der Erfindung ist es, ein Verfahren zur Reduzierung der Daten gemäß dem Oberbegriff derart weiterzubilden, daß es den Anforderungen für professionelle Anwendungen in Studios geeignet ist.

Diese Aufgabe wird durch ein Verfahren mit den Merkmalen des Anspruchs 1 gelöst.

Weiterbildungen und Ausgestaltungen der Erfindung sind in den abhängigen Ansprüchen gekennzeichnet.

Erfindungsgemäß erfolgt die Abbildung des Audiosignals aus dem Zeitbereich in den Frequenzbereich mit einer Filterbank mit perfekter Rekonstruktion. Das heißt, ohne Quantisierung und Codierung stimmt das in den Zeitbereich zurückübertragene Signal mit dem Eingangssignal vollständig überein.

Auf diese Weise trägt ausschließlich die Quantisierung zu einem Codierfehler bei. Wenn dieser Fehler im Bereich der Amplitudenauflösung gehalten werden kann, führt eine Nachbearbeitung des Signals zu keinen hörbaren Störungen. Um den durch die Quantisierung und Codierung verursachten Fehler gering zu halten, wird der psychoakustische Verdeckungseffekt nicht voll ausgenützt.

Aus dem Lehrbuch E.Zwicker Psychoakustik, Springer-Verlag 1982, Kapitel 2 und 3, ist bekannt, daß die Mithörschwelle denjenigen Schalldruckpegel eines Schalls angibt, den dieser haben muß, damit er neben einem Störfall gerade noch wahrgenommen werden kann.

Bei bekannten Verfahren wird ein betrachteter Blockabschnitt mit einer so geringen Anzahl an Bits codiert, daß das durch die Quantisierung verursachte Rauschen noch unterhalb der Mithörschwelle liegt, also von dem Musiksignal verdeckt wird. Durch Nachbearbeitung des Signals kann das zunächst verdeckte Quantisierungsrauschen zu einem hörbaren störenden Geräusch werden.

Deshalb wird erfindungsgemäß bei der Quantisierung und Codierung der psychoakustische Verdeckungseffekt, verglichen mit dem genannten ASPEC-Verfahren, höchstens zur Hälfte ausgenützt. Dadurch wird ein Abstand zwischen verdecktem und verdeckendem Signal erreicht, der eine Nachbearbeitung des Musiksignals ermöglicht.

Die Codierung erfolgt bei dem erfindungsgemäßen Verfahren mit variabler Wortlänge, wobei als Code ein kaskadierter, mehrdimensionaler Huffmancode verwendet wird.

Die Huffmancodierung wird somit anders als bei bekannten Verfahren (z.B. ASPEC) ausgeführt. Bei bekannten Verfahren treten aufgrund der hohen Datenreduktion überwiegend niedrige Werte auf, die codiert werden müssen. Diesen Werten werden mittels einer Huffman-Code-Tabelle Codeworte zugeteilt. Die Codierung sehr großer quantisierter Werte, die in der Tabelle nicht enthalten sind, erfolgt mit Hilfe einer Kennung, die einen weiteren Codierschritt einleitet.

Im Unterschied dazu erfolgt bei dem erfindungsgemäßen Verfahren, bei dem viel mehr hohe Werte codiert werden müssen, die Codierung mit verschiedenen Huffman-Code-Tabellen. Zunächst wird entschieden, in welchen Bereich der Wert fällt. Entsprechend diesem Bereich wird das Codewort mittels der geeigneten Huffman-Code-Tabelle zugeordnet.

Wenn der quantisierte Wert eine bestimmte Schwelle überschreitet, wird der die Schwelle übersteigende Anteil skalar codiert. Bei kleinen Werten erfolgt die Codierung in bekannter Weise.

Nach dem oben genanntem Lehrbuch von E. Zwicker, Kapitel 13 können Eigenschaften des menschlichen Gehörs mit der Erregungspegel-Tonheitsmuster-Darstellung veranschaulicht werden. In dieser Darstellung bleibt die untere Flanke bei allen Mustern (Frequenzen) gleich. Sie besitzt eine Flankensteilheit von etwa 27 dB / Bark. Wenn ein Störsignal unterhalb der Einhüllenden des Erregungspegel-Tonheitsmusters liegt, wird es vom menschlichen Gehör nicht wahrgenommen (Mithörschwelle).

Zur Berechnung der Verdeckungseffekte wird bei bekannten Verfahren die Kurve der Mithörschwellen (englisch "spreading function") verwendet. Um das Verhältnis von verdeckendem zu verdecktem Signal zu erhöhen, wird erfindungsgemäß anstelle der aus der Psychoakustik gewonnenen Kurve der Mithörschwellen, eine Kurve mit wenigstens zweifacher Flankensteilheit gewählt. Vorzugsweise werden die Flanken der Kurve der Mithörschwellen so steil gewählt, daß nur noch eine geringe Verdeckung angenommen wird. Bei dieser Codierung gelangt das Quantisierungsrauschen durch eine Nachbearbeitung wie die Filterung für die Abgleichung des Signals nicht in einen hörbaren Bereich.

Nach Anspruch 2 liegt die Amplitude des durch die Quantisierung entstehenden Rauschens mindestens 14 dB unterhalb des verdeckenden Audiosignals. Damit wird sichergestellt, daß auch bei mehrfacher Anwendung des Verfahrens keine hörbare Verschlechterung des Musiksignals auftritt.

Um mögliche Probleme bei einer späteren Verstärkung von Audiosignalen mit geringer Amplitude zu umgehen, wird für die Grundhörschwelle ein Pegel angenommen der mindestens 10 dB unterhalb der Amplitudenauflösung (englisch "least significant Bit") liegt.

Bei einer besonders vorteilhaften Ausgestaltung der Erfindung nach Anspruch 3, wird als Filterbank eine Modifizierte Diskrete Cosinus-Transformation (MDCT) verwendet, die gemäß Anspruch 4 mit einer Blocklänge von 256 oder 512 Abtastwerten benutzt wird. Bei einer Abtastfrequenz von 48 kHz ergeben sich, daraus Blocklängen von 5,33 bzw. 10,67 msec.

Die MDCT ist eine Transformation mit perfekter Rekonstruktion, das heißt, daß das Ausgangssignal der Synthese-Filterbank genau gleich dem Eingangssignal der Analyse-Filterbank ist, wenn keine Quantisierung durchgeführt wird. Die Option zur Benutzung einer Blocklänge von 256 Abtastwerten ermöglicht eine Erhöhung der Zeitauflösung bei verringerter Effizienz der Codierung.

Nach Anspruch 5 beinhaltet das Analysefenster 512 oder 1024 Abtastwerte und ist demnach bei einer Abtastrate von 48 kHz 10,67 oder 21,33 msec lang. Neben den bei üblichen Verfahren verwendeten Abtastfrequenzen von 32 kHz, 44,1 kHz und 48 kHz, unterstützt das Verfahren auch eine Abtastfrequenz von 96 kHz. Bei dieser Abtastfrequenz können mit dem Verfahren Frequenzen weit oberhalb des menschlichen Wahrnehmungsvermögens übertragen werden. Dies wird manchmal als Forderung für Studioanwendungen genannt.

Eine vorteilhafte Weiterbildung der Erfindung ist in Anspruch 7 gekennzeichnet. Danach wird das codierte Signal nachbearbeitet, beispielsweise aus- oder eingeblendet. Hierzu kann das codierte Signal in einen Rechner eingegeben und direkt bearbeitet werden. Mit diesem Verfahren können große Einsparungen bei der digitalen Prozeßverarbeitung und der Speicherzuweisung erzielt werden.

Da in einem Tonstudio in der Regel viele Musikkanäle gemischt werden, können bei einer Weiterbildung der Erfindung gemäß Anspruch 8 bis zu 48 Kanäle parallel verarbeitet werden.

Ein wesentlicher Vorteil der Erfindung besteht darin, daß ein mit dem Verfahren bearbeitetes digitales Musiksignal für professionelle Anwendungen in Tonstudios geeignet ist. Das Signal kann gemischt und überblendet werden, es kann mit sehr unterschiedlichen Lautstärken abgespielt werden, es kann mehrfach hintereinander codiert und decodiert werden, ohne daß eine Verschlechterung des Tonsignals wahrnehmbar ist.

Das Signal kann mit einem Nachhall oder anderen Effekten versehen werden. Alle die genannten Maßnahmen können auf einzelne Kanäle angewendet werden, die zu einem Gesamtsignal zusammengesetzt werden.

Im Gegensatz zu Verfahren der Datenreduktion, die kein verfahrensbedingtes Rauschen erzeugen, wie sie beispielsweise zur Speicherung von Computerdaten eingesetzt werden, leistet das erfindungsgemäße Verfahren eine wesentlich stärkere Reduktion.

Mit dem Verfahren kann eine nahezu perfekte Rekonstruktion des Musiksignals erreicht werden, wobei pro Abtastwert nur 4 bis 6 Bit benötigt werden. Damit wird im Vergleich zu dem Originalsignal von 16 oder 20 Bit pro Abtastwert ein Reduktionsfaktor von 4 bis 5 erreicht. Die typische Bitrate beträgt 192 kBit/sec bei nahezu verlustloser Übertragung.

### Weg zur Ausführung der Erfindung

Nachfolgend wird ein Ausführungsbeispiel des erfindungsgemäßen Verfahrens näher beschrieben.

Ein digitales Audiosignal wird durch eine Modifizierte Diskrete Cosinus-Transformation aus dem Zeitbereich in den Frequenzbereich abgebildet, um das Eingangssignal in unterabgetastete Spektralkomponenten zu zerlegen. Die Abtastfrequenz beträgt 48 kHz, die Blocklänge 516 Abtastwerte bzw. 10,67 msec. Die Fensterbreite beträgt 1024 Abtastwerte.

Die Ausgangssignale dieser Filterbank werden zur Berechnung von Schätzwerten der jeweiligen signalabhängigen Mithörschwellen benutzt. Dazu werden aus der Psychoakustik bekannte Gesetzmäßigkeiten verwendet. Allerdings wird zur Bestimmung der minimalen Mithörschwelle ein modifiziertes akustisches Modell herangezogen. Als Grundlage dient das Modell 2 des Codierers des nicht veröffentlichten ISO/MPEG Standard 11172-3 (International Standarisation Organisation/Moving Pictures Experts Group), das jedoch in wesentlichen Punkten abgeändert wird. Die Steigung der Flanken der Kurve der Mithörschwelle wird so stark erhöht, daß nur eine minimale Verdeckung berücksichtigt wird. Als besonders vorteilhaft erweist sich die Verwendung einer Kurve der Mithörschwelle mit einer Steigung der Flanken, die wenigstens die zweifache Flankensteilheit der Kurve des Modells 2 des ISO/MPEG Standards aufweist. Der Abstand zwischen dem verdeckenden Signal und dem verdeckten Rauschen beträgt statt 6 - 9 dB 20 dB für rauschähnliche Signale. Die Quantisierung des Signals erfolgt mit einem linearen Quantisierer, weil, dieser ein optimales Verhältnis von verdeckendem Signal und verdecktem Rauschen ermöglicht.

Die Codierung der quantisierten Spektralwerte erfolgt mit Hilfe einer Huffman-Codierung. Da wesentlich mehr große Werte, als beispielsweise bei dem bekannten ASPEC-Verfahren zu codieren sind, werden die Code-Tabellen anders organisiert. Die Codierung großer Werte erfolgt dadurch, daß festgestellt wird, in welchen Bereich der Wert fällt. Aus verschiedenen Huffman-Code-Tabellen wird dann die dem Bereich entsprechende ausgewählt. Wenn die quantisierten Werte eine bestimmte Schwelle überschreiten, werden durch die Tabelle scalare Werte anstelle von Wertepaaren codiert.

Die codierten Werte und die Seiteninformationen werden zu einem Ausgangs-Bitstrom zusammengefaßt.

Da das psychoakustische Modell nur im Codierer verwendet wird und nicht im Decodierer, kann das Modell geändert werden, ohne die Definition des Bitstromes zu verändern.

Um einen möglichst einfachen Codierer zur Durchführung des Verfahrens aufzubauen, können den jeweiligen Anforderungen angepaßte, andere akustische Modelle zugrundegelegt werden.

## Patentansprüche

1. Verfahren zur Datenreduktion bei der Speicherung und/oder Übertragung digitaler Audiosignale, bei welchem ein digitales Audiosignal vor der Speicherung und/oder Übertragung mit Hilfe einer Filterbank aus dem Zeitbereich in den Frequenzbereich abgebildet wird und aus dem Signal im Frequenzbereich unter Ausnutzung des psychoakustischen Verdeckungseffektes irrelevante bzw. redundante Informationen ausgeschieden werden, bei welchem das Signal quantisiert und mit variabler Wortlänge codiert wird, wobei als Code variabler Wortlängen eine Codierung mit verschiedenen Huffmann-Code-Tabellen verwendet wird und bei welchem das Signal nach Auslesen aus dem Speicher und/oder Übertragung decodiert und aus dem Frequenzbereich in den Zeitbereich abgebildet wird, **dadurch gekennzeichnet**, daß die Abbildung des Audiosignals mit einer Filterbank mit perfekter Rekonstruktion erfolgt, daß der psychoakustische Verdeckungseffekt maximal zur Hälfte ausgenutzt wird, daß bei der Codierung zunächst entschieden wird, in welchen Bereich der zu codierende Wert fällt und entsprechend diesem Bereich das Codewort mittels der geeigneten Huffmann-Code-Tabelle zugeordnet wird, daß, falls der quantisierte Wert eine vorgegebene Schwelle überschreitet, der die Schwelle übersteigende Anteil skalar codiert wird, und daß zur Berechnung der Vedeckungseffekte anstelle der Kurve der Mithörschwellen eine Kurve mit wenigstens zweifacher Flankensteilheit eingesetzt wird

2. Verfahren nach Anspruch 1, **dadurch gekennzeichnet**, daß für rauschartige Signale eine Maskierungsschwelle verwendet wird, die mindestens 14 dB unterhalb der Signalamplitude liegt.

3. Verfahren nach einem der Ansprüche 1 bis 2, **dadurch gekennzeichnet**, daß als Filterbank eine Modifizierte Diskrete Cosinus-Transformation MDCT verwendet wird.

4. Verfahren nach Anspruch 3, **dadurch gekennzeichnet**, daß die MDCT mit einer Blocklänge von 256 oder 512 Abtastwerten benutzt wird.

5. Verfahren nach den Ansprüchen 3 oder 4, **dadurch gekennzeichnet**, daß ein Analysefenster von 512 oder 1024 Abtastwerten vorgesehen ist.

6. Verfahren nach einem der Ansprüche 1 bis 5, **dadurch gekennzeichnet**, daß die ankommenden Audiosignale wahlweise mit einer Abtastfrequenz von 32 kHz, 44,1 kHz, 48 kHz oder 96 kHz abgetastet werden.

7. Verfahren nach einem der Ansprüche 1 bis 6, **dadurch gekennzeichnet,** daß das codierte Signal nachbearbeitet, beispielsweise ausgeblendet oder eingeblendet wird.

8. Verfahren nach einem der Ansprüche 1 bis 7, **dadurch gekennzeichnet**, daß bis zu 48 Kanäle parallel verarbeitet werden.

## Claims

1. Method of data compression in the storage and/or transmission of digital audio signals, in which a digital audio signal is mapped from the time domain into the frequency domain before storage and/or transmission with the aid of a filter bank, and irrelevant or redundant information is eliminated from the signal in the frequency domain using the psycho-acoustic masking effect, in which method the signal is quantized and encoded with variable word length, coding with different Huffmann code tables being used as the code of variable word lengths, and in which method the signal is decoded after retrieval from the memory and/or transmission and mapped from the frequency domain into the time domain, **characterised in that** the mapping of the audio signal with a filter bank comes about with perfect reconstruction, in that the psycho-acoustic masking effect is at the maximum only half exploited, in that in the encoding it is first of all decided into which domain the value to be encoded falls and according to this domain the code word is allocated by means of the appropriate Huffmann code table, in that, if the quantized value exceeds a pre-determined threshold, the portion exceeding the threshold is encoded in scalar manner, and in that, to calculate the masking effects, instead of the curve of the masked thresholds, a curve with at least double edge steepness is used.

2. Method according to claim 1, **characterised in that** a masking threshold is used for noise-like signals, which lies at least 14dB below the signal amplitude.

3. Method according to one of claims 1 to 2, **characterised in that** a modified discreet cosine transformation (MDCT) is used as the filter bank.

4. Method according to claim 3, **characterised in that** the MDCT is used with a block length of 256 or 512 sampled values.

5. Method according to claims 3 or 4, **characterised in that** an analysis window of 512 or 1024 sampled values is provided.

6. Method according to one of claims 1 to 5, **characterised in that** the arriving audio signals are optionally sampled with a sampling frequency of 32 kHz, 44.1 kHz, 48 kHz or 96 kHz.

7. Method according to one of claims 1 to 6, characterised in that the coded signal is post-processed, for example faded out or faded in.

8. Method according to one of claims 1 to 7, **characterised in that** up to 48 channels are processed in parallel.

## Revendications

1. Procédé de réduction des données pour l'enregistrement et/ou la transmission de signaux audio numériques, selon lequel,
- on copie un signal audio numérique avant son enregistrement en mémoire et/ou sa transmission, à l'aide d'un banc de filtres, à partir de la plage de temps dans la plage de fréquence et à partir du signal dans la plage de fréquence, en utilisant l'effet de chevauchement psycho-acoustique, on élimine les informations non déterminantes ou redondantes,
- on quantifie le signal et on le code à une longueur de mot variable, et comme code pour les longueurs de mot variable, on utilise un codage avec différents tableaux de code Huffmann, et
- on décode le signal après sa lecture dans la mémoire et/ou sa transmission et on le copie du domaine de fréquence dans le domaine du temps,
caractérisé en ce que
- la copie du signal audio se fait à l'aide d'un banc de filtres à reconstruction parfaite,
- on utilise l'effet de chevauchement psychoacoustique au maximum à moitié,
- pour le codage, on décide tout d'abord dans quel domaine tombe la valeur à coder et en fonction de ce domaine, on attribue le mot de code à l'aide du tableau approprié de code Huffmann,
- si la valeur quantifiée dépasse un seuil prédéterminé, on codifie de manière scalaire la partie dépassant le seuil, et
- pour calculer l'effet de chevauchement, à la place de la courbe des seuils des auditeurs, on utilise une courbe avec au moins une pente double des flancs.

2. Procédé selon la revendication 1,
caractérisé en ce que
pour les signaux de bruit, on utilise un seuil de masquage qui se situe au moins à 14 dB en dessous de l'amplitude du signal.

3. Procédé selon l'une des revendications 1 et 2,
caractérisé en ce que
le banc de filtres utilise une transformation cosinus discrète, modifiée, (MDCT).

4. Procédé selon la revendication 3,
caractérisé en ce que
la transformation MDCT utilise une longueur de bloc à 256 ou 512 valeurs de détection.

5. Procédé selon l'une des revendications 3 ou 4,
caractérisé par
une fenêtre d'analyse à 512 ou 1024 valeurs de détection.

6. Procédé selon l'une quelconque des revendications 1 à 5, caractérisé en ce que
les signaux audio d'entrée sont détectés sélectivement avec une fréquence de détection de 32 kHz, 44,1 kHz, 48 kHz ou 96 kHz.

7. Procédé selon l'une quelconque des revendications 1 à 6, caractérisé en ce qu'
on traite le signal codé par exemple, on l'élimine ou on l'injecte.

8. Procédé selon l'une quelconque des revendications 1 à 7,
caractérisé en ce qu'
on traite en parallèle jusqu'à 48 canaux.
